Europäisches Patentamt

European Patent Office

Office européen des brevets

(19)

(11) Numéro de publication: **0 078 190**
**B1**

(12)                    FASCICULE DE BREVET EUROPEEN

(45) Date de publication du fascicule du brevet:
03.07.85

(51) Int. Cl.⁴: **H 01 L 21/31, H 01 L 21/90**

(21) Numéro de dépôt: **82401873.3**

(22) Date de dépôt: **12.10.82**

(54) Procédé de fabrication de résistances de forte valeur pour circuits intégrés.

(30) Priorité: **27.10.81 FR 8120165**

(43) Date de publication de la demande:
**04.05.83 Bulletin 83/18**

(45) Mention de la délivrance du brevet:
**03.07.85 Bulletin 85/27**

(84) Etats contractants désignés:
**CH DE FR GB IT LI NL**

(56) Documents cités:
**FR - A - 2 269 199**

**IBM TECHNICAL DISCLOSURE BULLETIN, vol. 23, no. 6, novembre 1980, pages 2563-2566, New York (USA); V.L. RIDEOUT: "Method of fabricating mosfet integrated circuits with low resistivity interconnection lines".**
**IBM TECHNICAL DISCLOSURE BULLETIN, vol. 23, no. 7A, decembre 1980, pages 2811-2812, New York (USA); J.R. LLOYD et al.: "Polysilicon resistor fabrication".**

(73) Titulaire: **SOCIETE POUR L'ETUDE ET LA FABRICATION DE CIRCUITS INTEGRES SPECIAUX - E.F.C.I.S., 17, avenue des Martyrs, F-38100 Grenoble (FR)**

(72) Inventeur: **Dubois, Guy, THOMSON-CSF SCPI 173, bld Haussmann, F-75379 Paris Cedex 08 (FR)**

(74) Mandataire: **de Beaumont, Michel et al, THOMSON-CSF SCPI 173, Bld Haussmann, F-75379 Paris Cedex 08 (FR)**

## Description

La présente invention concerne un procédé de fabrication de résistances de forte valeur compatible avec un processus de fabrication de circuits intégrés de type MOS (métal-oxyde-semiconducteur) selon lequel les lignes d'accès à certaines bornes (grille, drain et/ou source) des transistors élémentaires sont réalisées au moyen de bandes conductrices constituées de la superposition d'une bande de silicium polycristallin fortement dopé et d'une bande d'un siliciure métallique.

On connaît actuellement de nombreux procédés pour former des résistances de forte valeur sur des circuits intégrés de type MOS. Notamment, il existe des procédés pour former des résistances dans des portions de bandes de silicium polycristalin, ces portions ayant une forte résistivité et le reste de la bande ayant une faible résistivité pour permettre une bonne conduction et assurer la circulation du courant. Néanmoins, ces procédés présentent un ou plusieurs des inconvénients suivants:

— non-compatibilité avec un processus dans lequel les bandes conductrices d'accès à certaines bornes des transistors MOS élémentaires (généralement, les grilles) sont constituées de la superposition d'une bande de silicium polycristallin conductrice et d'une bande d'un siliciure métallique tel que du silicium de tantale $TaSi_2$,

— nécessité d'utilisation d'au moins trois masques successifs alors que l'on sait que, dans le domaine des circuits intégrés, on tend toujours à diminuer le nombre de masquages pour éviter les problèmes liés à l'alignement mutuel des masques successifs et en conséquence permettre une miniaturisation des circuits,

— emploi de technologies particulièrement délicates à mettre en œuvre du fait, par exemple, qu'elles ne peuvent être suivies d'étapes de recuit ou encore qu'elles nécessitent des attaques chimiques sélectives délicates, par exemple pour effectuer une attaque de silicium polycristallin fortement dopé de façon sélective par rapport à du nitrure de silicium.

Ainsi, un objet de la présente invention est de prévoir un procédé de fabrication de résistances de forte valeur dans le cadre d'un processus de fabrication de circuits intégrés de type MOS selon lequel les lignes d'accès à certaines bornes des transistors élémentaires sont réalisées au moyen de bandes conductrices constituées de la superposition d'une bande de silicium polycristallin fortement dopé et d'une bande de siliciure métallique, ce procédé évitant les trois inconvénients exposés précédemment des procédés usuels. Ainsi, le procédé selon l'invention est compatible avec une technologie silicium polycristallin/siliciure métallique, ne nécessite que deux masques pour la réalisation des résistances, et n'utilise pas d'étapes d'attaque sélective particulièrement délicates.

Selon le procédé de l'invention, les résistances sont réalisées au-dessus de la surface du semiconducteur dans lequel est réalisé le circuit intégré, sur une couche d'oxyde épais. Ce procédé comprend les étapes consistant à: déposer sur la pastille une couche de silicium polycristallin ayant une forte résistivité; former par dépôt et masquage aux emplacements où l'on souhaite placer les résistances de pions d'un produit photosensible; doper le silicium polycristallin pour lui faire acquérir une faible résistivité sauf aux emplacements protégés par les pions de produit photosensibles; déposer sur la pastille une couche de siliciure métallique; éliminer par attaque chimique les pions et les portions de siliciure qui les recouvrent, cette étape étant souvent désignée dans la technique sous l'appellation anglo-saxonne «lift off»; et masquer la surface de la pastille et procéder à une attaque du siliciure et du silicium polycristallin pour former des lignes dont certaines au moins passent sur lesdits pions. Le siliciure métallique peut être du siliciure de tantale $TaSi_2$ et l'ordre de réalisation des deux dernières étapes du procédé peut être inversé.

Ces caractéristiques et avantages de la présente invention ainsi que d'autres ressortiront de la description suivante d'un mode de réalisation particulier faite en relation avec les figures jointes parmi lesquelles:

les fig. 1A, 2A et 3A représentent des vues en coupe d'étapes successives de fabrication de résistances selon le procédé de l'invention, et

les fig. 1B, 3B et 4B représentent des vues de dessus d'étapes successives de fabrication.

Conformément à l'usage dans le domaine de la représentation des semi-conducteurs, ces figures ne sont absolument pas tracées à l'échelle, mais les épaisseurs relatives et les distances entre les diverses couches ont été modifiées pour facilitier leur lisibilité. Pour la mise en œuvre du procédé, l'homme de l'art se référera aux connaissances habituelles dans le domaine ou aux données particulières indiquées ci-après. De mêmes références sont utilisées pour désigner des éléments ou couches analogues.

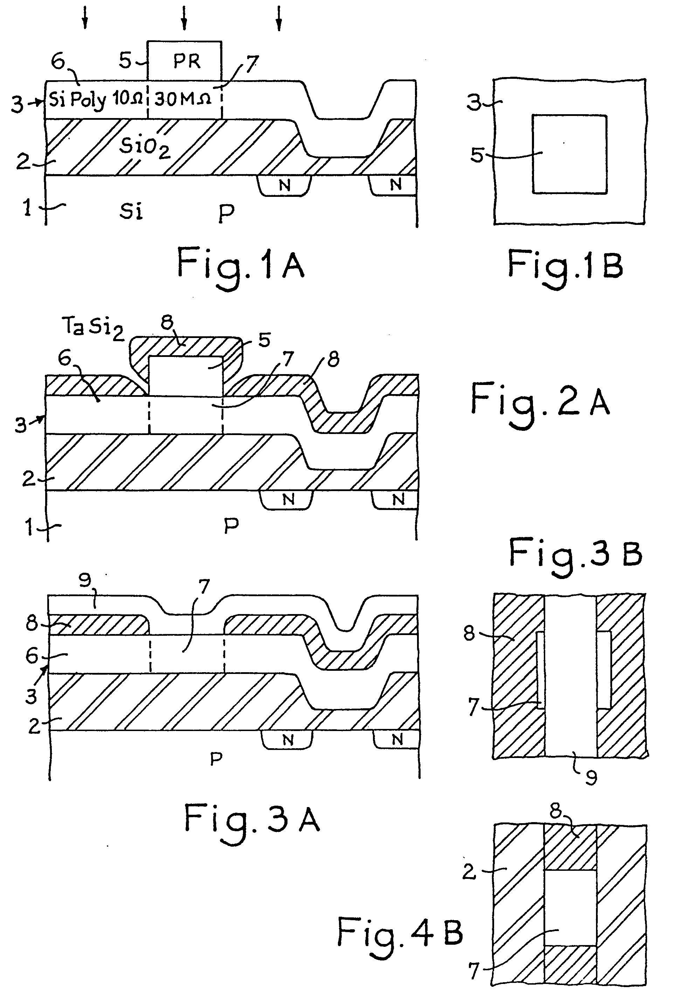

La fig. 1A représente une étape intermédiaire de fabrication d'une résistance selon l'invention. Sur une tranche semi-conductrice 1, couramment du silicium, est déposée une couche isolante 2, par exemple de la silice, cette couche présentant des épaisseurs différentes en divers emplacements. Dans la partie gauche de la figure, on a représenté une zone où la couche de silice est épaisse et au-dessus de laquelle sera formée la résistance selon l'invention. Dans la partie droite de la figure, on a représenté une zone où la couche de silice est plus mince, zone qui correspond à la grille d'un transistor à effet de champ de type MOS. Dans l'étape de la fig. 1A, la tranche est uniformément revêtue d'une couche de silicium polycristallin 3 de forte résistance, par exemple 30 mégohms/carré, cette résistance étant obenue *in situ* au moment du dépôt de la couche de silicium polycristallin ou par suite d'un dopage ultérieur pouvant être réalisé par diffusion ou implantation. La couche de silicium polycristallin est recouverte d'une couche uniforme d'un produit photosensible PR qui sera appelé ci-après résine. On procède alors à une étape de masquage et d'attaque pour maintenir seulement des pions de résine 5 aux emplacements où l'on souhaite former des résistances.

Après cela, on procède à une implantation d'un produit dopant pour augmenter la conductivité du silicium polycristallin aux emplacements non protégés par les pions de résine 5. On obtient des zones 6 où le silicium polycristallin a une résistivité faible de l'ordre de 10 ohms/carré et des zones 7 situées sous les pions de résine 5 où le silicium polycristallin a sa résistivité initiale de l'ordre, par exemple, de 30 mégohms/carré.

Comme le montre la fig. 2A, on dépose ensuite une couche uniforme d'un siliciure métallique sur la pastille, par exemple du siliciure de tantale TaSi₂. On procède alors à une attaque sélective de la résine pour éliminer le pion 5 en même temps que la portion de couche de siliciure de tantale qui le surmonte. Ce procédé est souvent désigné sous l'appellation anglo-saxonne «procédé de lift off».

On procède ensuite à une étape de masquage par une bande de résine 9 (voir les fig. 3A et 3B), et d'attaque pour découper simultanément en forme de bandes le siliciure de tantale 8 et la couche de silicium polycristallin sous-jacente 3. En effet, il existe actuellement des produits d'attaque chimique, permettant d'attaquer sélectivement le siliciure de tantale 8 et le silicium polycristallin 3, par rapport à la silice 2 et à la résine 9 (par exemple gravure sèche par un plasma fluoré pur ou chloré). Ce type d'attaque sélective est relativement simple à réaliser alors que, par exemple, une attaque d'une couche de silicium polycristallin fortement conducteur sélective vis-à-vis d'une couche de nitrure de silicium aurait été délicate à réaliser. On obtient ainsi une résistance telle que représentée dans la vue de dessus de la fig. 4B dont la dimension longitudinale est déterminée par le pion de résine 5 et les dimensions transverales par la largeur de la bande de résine 9.

Le procédé selon la présente invention comprend seulement deux étapes de masquage, à savoir l'étape de formation des pions de résine 5 illustrée en fig. 1A et 1B, et l'étape de découpe des bandes de siliciure de tantale et de silicium polycristallin illustrée en fig. 3B et 4B, ce qui permet d'obtenir des éléments résistifs de dimensions minimisées. En outre il n'y a pas d'exigence d'alignement rigoureux entre ces deux étapes de masquages: comme le montre la fig. 3B, l'existence d'un décalage entre le masque des pions et celui des bandes n'a pas d'influence néfaste sur le résultat du moment que les dimensions transversales des pions ont été légèrement surdimensionnées par rapport à celles des bandes.

On notera également que l'on pourrait effectuer le «lift off» du pion de résine 5 et du siliciure de tantale qui le recouvre seulement après gravure en bande du siliciure de tantale et du silicium polycristallin.

## Revendications

1. Procédé de fabrication de résistances de forte valeur dans le cadre d'un processus de fabrication de circuits intégrés selon lequel les lignes d'accès à certaines bornes des transistors élémentaires sont réalisées au moyen de bandes conductrices constituées de la superposition d'une bande de silicium polycristallin fortement dopé (6) et d'une bande d'un siliciure métallique (8), ces résistances étant réalisées en des emplacements où la pastille de circuit intégré est revêtue d'une couche d'oxyde épais (2), caractérisé en ce qu'il comprend les étapes suivantes:

— déposer sur la pastille une couche de silicium polycristallin (3) ayant une forte résistivité;

— former, par dépôt et masquage, aux emplacements où l'on souhaite placer des résistances, des pions d'un produit photosensible (2);

— doper le silicium polycristallin (6) pour lui faire acquérir une faible résistivité sauf aux emplacements (7) protégés par le produit photosensible (5);

— déposer sur la pastille une couche d'un siliciure métallique (8);

— éliminer par attaque chimique, les pions et les portions de siliciure qui les recouvrent («lift off»), et

— masquer la surface de la pastille et attaquer le siliciure et le silicium polycristallin pour former des lignes dont certaines au moins passent sur lesdits pions, ces attaques étant sélectives vis-à-vis du produit photosensible et de la silice.

2. Procédé selon la revendication 1, caractérisé en ce que le siliciure métallique est du siliciure de tantale.

3. Procédé selon la revendication 1, caractérisé en ce que l'ordre de réalisation des deux dernières étapes est inversé.

## Patentansprüche

1. Verfahren zur Herstellung von Widerständen mit grossem Wert, im Rahmen eines Herstellungsverfahrens für integrierte Schaltungen, bei welchem die Zuleitungen zu bestimmten Anschlüssen von elementaren Transistoren durch Leiterstreifen verwirklicht sind, die gebildet sind aus einer Übereinanderanordnung eines hoch dotierten polykristallinen Siliziumstreifens (6) und eines metallischen Silizids (8), wobei diese Widerstände an Stellen gebildet sind, wo das integrierte Schaltungsplättchen von einer dicken Oxidschicht (2) bedeckt ist, dadurch gekennzeichnet, dass es folgende Schritte umfasst:

— auf dem Plättchen wird eine polykristalline Siliziumschicht (3) von hohem spezifischen Widerstand aufgebracht;

— durch Ablagerung und Maskierung werden an den Stellen, wo die Widerstände angeordnet werden sollen, Klötzchen (5) aus einem photoempfindlichen Material gebildet;

— das polykristalline Silizium (6) wird dotiert, damit es einen geringen spezifischen Widerstand erhält, ausser an den Stellen (7), die durch das photoempfindliche Material (5) geschützt sind;

— auf dem Plättchen wird eine Schicht aus metallischem Silizid (8) abgelagert;

— durch chemische Ätzung werden die Klötzchen und die Silizidteile beseitigt, welche sie bedecken („lift off"), und

— die Plättchenoberfläche wird maskiert, und das Silizid sowie das polykristalline Silizium werden geätzt, um Linien zu bilden, von denen wenigstens einige über den genannten Klötzchen verlaufen, wobei diese Ätzungen gegenüber dem photoempfindlichen Material und dem Siliziumdioxid selektiv sind.

2. Verfahren nach Anspruch 1, dadurch gekennzeichnet, dass das metallische Silizid Tantalsilizid ist.

3. Verfahren nach Anspruch 1, dadurch gekennzeichnet, dass die Reihenfolge der Ausführung der zwei letzten Schritte vertauscht ist.

## Claims

1. Method of fabricating resistances of high value within the framework of a fabricating method for integrated circuits in which the leads to certain terminals of elementary transistors are realized by conductor strips which are formed by superimposing a highly doped polycrystalline silicon strip (6) and a metallic silicide (8), said resistances being formed at locations where the integrated circuit wafer is covered by a thick oxide layer (2), characterized in that it comprises the following steps:

— depositing on the wafer a polycristalline silicon layer (3) of high resistivity;

— forming by deposition and masking at the locations where the resistances are to be arranged blocks (5) of a photosensitive material;

— doping the polycrystalline silicon (6) so that it acquires a low resistivity except for the locations (7) protected by the photosensitive material (5);

— depositing on the wafer a layer of metallic silicide (8);

— removing by chemical etching the blocks and the silicide portions covering them ("lift off"), and

— masking the wafer surface and etching the silicide and the polycrystalline silicon to form lines of which at least some extend over said blocks, said etchings being selective with respect to the photosensitive material and the silica.

2. Method according to Claim 1, characterized in that the metallic silicide is tantalum silicide.

3. Method according to Claim 1, characterized in that the order of the execution of the two last steps is reversed.

Fig.1A

Fig.1B

Fig.2 A

Fig.3 B

Fig.3 A

Fig.4 B